**Europäisches Patentamt**

**European Patent Office**

**Office européen des brevets**

(19)

(11) **EP 1 571 755 A2**

(12) **EUROPÄISCHE PATENTANMELDUNG**

(43) Veröffentlichungstag:
**07.09.2005 Patentblatt 2005/36**

(51) Int Cl.$^7$: **H03M 7/40**, G06T 9/00

(21) Anmeldenummer: **05009246.9**

(22) Anmeldetag: **02.05.2003**

(84) Benannte Vertragsstaaten:
**AT BE BG CH CY CZ DE DK EE ES FI FR GB GR HU IE IT LI LU MC NL PT RO SE SI SK TR**

(30) Priorität: **02.05.2002 DE 10220962**

(62) Dokumentnummer(n) der früheren Anmeldung(en) nach Art. 76 EPÜ:
**03725141.0 / 1 550 219**

(71) Anmelder: **Fraunhofer-Gesellschaft zur Förderung der angewandten Forschung e.V. 80686 München (DE)**

(72) Erfinder:
• **Marpe, Detlef**
  **12161 Berlin (DE)**

• **Wiegand, Thomas**
  **10789 Berlin (DE)**

(74) Vertreter: **Schenk, Markus et al Patentanwälte Schoppe, Zimmermann Stöckeler & Zinkler Postfach 246 82043 Pullach (DE)**

Bemerkungen:
Diese Anmeldung ist am 27 - 04 - 2005 als Teilanmeldung zu der unter INID-Kode 62 erwähnten Anmeldung eingereicht worden.

(54) **Verfahren und Anordnung zur arithmetischen Enkodierung und Dekodierung mit Initialisierung eines Wahrscheinlichkeitsmodelles**

(57) Die Erfindung beschreibt ein Verfahren und eine Anordnung zur arithmetischen Enkodierung und Dekodierung von binären Zuständen sowie ein entsprechendes Computerprogramm und ein entsprechendes computerlesbares Speichermedium, welche insbesondere bei der digitalen Datenkompression eingesetzt werden können.

Hierfür wird vorgeschlagen, beispielsweise eine tabellengestützte binäre arithmetische Enkodierung und Dekodierung unter Verwendung von zwei oder mehreren Tabellen durchzuführen.

```
1. preState = min(max( 1,((m * SliceQP )>>4)+n),126)
2. if (preState <= 63) then
      p_state = 63 - preState
      valMPS = 0
   else
      p_state = preState - 64
      valMPS = 1
```

Figur 6

**Beschreibung**

Die Erfindung betrifft ein Verfahren und eine Anordnung zur arithmetischen Enkodierung und Dekodierung von binären Zuständen sowie ein entsprechendes Computerprogramm und ein entsprechendes computerlesbares Speichermedium, welche insbesondere bei der digitalen Datenkompression eingesetzt werden können.

Die vorliegende Erfindung beschreibt ein neues effizientes Verfahren zur binären arithmetischen Kodierung. Der Bedarf nach binärer arithmetischer Kodierung entsteht in den verschiedensten Anwendungsbereichen der digitalen Datenkompression; hier sind vor allem Anwendungen in den Bereichen der digitalen Bildkompression von beispielhaften Interesse. In zahlreichen Standards zur Bildkodierung, wie etwa JPEG, JPEG-2000, JPEG-LS und JBIG wurden Verfahren zur binären arithmetischen Kodierung definiert. Neuere Standardisierungsaktivitäten lassen auch den zukünftigen Einsatz derartiger Kodiertechniken im Bereich der Videokodierung (CABAC in H.264/AVC) erkennen [1].

Die Vorteile der arithmetischen Kodierung (AK) gegenüber der bisher in der Praxis häufig verwendeten Huffman-Kodierung [2] lassen sich im wesentlichen durch drei Merkmale charakterisieren:

1. Mit der Verwendung der arithmetischen Kodierung lässt sich durch einfache Adaptionsmechanismen eine dynamische Anpassung an die vorhandene Quellenstatistik erzielen (Adaptivität).
2. Die arithmetische Kodierung erlaubt die Zuweisung von einer nicht ganzzahligen Anzahl von Bits pro zu kodierendem Symbol und ist damit geeignet, Kodierresultate zu erzielen, die eine Approximation der Entropie als der theoretisch gegebenen unteren Schranke darstellen (Entropie-Approximation) [3].
3. Unter Zuhilfenahme geeigneter Kontextmodelle lassen sich mit der arithmetischen Kodierung statistische Bindungen zwischen Symbolen zur weiteren Datenreduktion ausnutzen (Intersymbol-Redundanz) [4].

Als Nachteil einer Anwendung der arithmetischen Kodierung wird der im Vergleich zur Huffman-Kodierung i. a. erhöhte Rechenaufwand angesehen.

Das Konzept der arithmetischen Kodierung geht zurück auf die grundlegenden Arbeiten zur Informationstheorie von Shannon [5]. Erste konzeptionelle Konstruktionsmethoden wurden in [6] erstmals von Elias veröffentlicht. Eine erste LIFO (last-in-first-out) Variante der arithmetischen Kodierung wurde von Rissanen [7] entworfen und später von verschiedenen Autoren zu FIFO-Ausbildungen (first-in-first-out) modifiziert [8] [9] [10].

Gemeinsam ist allen diesen Arbeiten das zugrundeliegende Prinzip der rekursiven Teilintervallzerlegung: Entsprechend den gegebenen Wahrscheinlichkeiten $P("0")$ und $P("1")$ zweier Ereignisse $\{"0", "1"\}$ eines binären Alphabets wird ein anfänglich gegebenes Intervall, z.B. das Intervall $[0, 1)$, je nach Auftreten von Einzelereignissen rekursiv in Teilintervalle zerlegt. Dabei ist die Größe des resultierenden Teilintervalls als Produkt der Einzelwahrscheinlichkeiten der aufgetretenen Ereignisse proportional zur Wahrscheinlichkeit der Folge der Einzelereignisse. Da jedes Ereignis $S_i$ mit der Wahrscheinlichkeit $P(S_i)$ einen Beitrag von $H(S_i) = -log(P(S_i))$ des theoretischen Informationsgehalts $H(S_i)$ von $S_i$ zur Gesamtrate beiträgt, ergibt sich eine Beziehung zwischen der Anzahl $N_{Bit}$ der Bits zur Darstellung des Teilintervalls und der Entropie der Folge von Einzelereignissen, die durch die rechte Seite der folgenden Gleichung angegeben ist

$$N_{Bit} = -log \Pi_i P(S_i) = -\Sigma_i log P(S_i) \ .$$

Das Grundprinzip erfordert jedoch zunächst eine (theoretisch) unbegrenzte Genauigkeit in der Darstellung des resultierenden Teilintervalls und hat darüber hinaus den Nachteil, dass erst nach Kodierung des letzten Ereignisses die Bits zur Repräsentierung des resultierenden Teilintervalls ausgegeben werden können. Für praktische Anwendungszwecke war es daher entscheidend, Mechanismen für eine inkrementelle Ausgabe von Bits bei gleichzeitiger Darstellung mit Zahlen vorgegebener fester Genauigkeit zu entwickeln. Diese wurden erstmals in den Arbeiten [3][7] [11] vorgestellt.

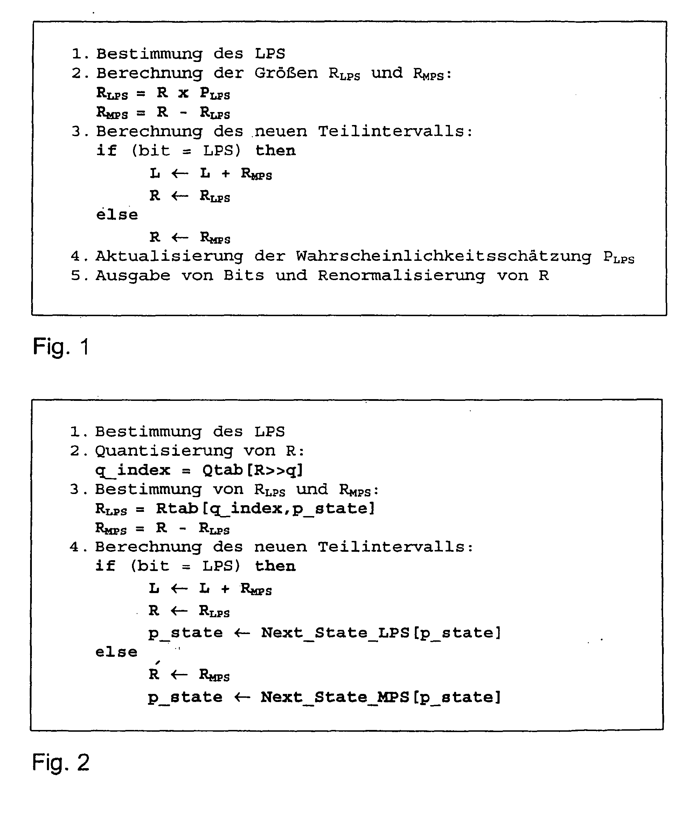

In Figur 1 sind die wesentlichen Operationen zur binären arithmetischen Kodierung skizziert. In der dargestellten Implementierung wird das aktuelle Teilintervall durch die beiden Werte $L$ und $R$ repräsentiert, wobei $L$ den Aufsatzpunkt und $R$ die Größe (Breite) des Teilintervalls bezeichnet und beide Größen mit jeweils b-bit Ganzzahlen dargestellt werden. Die Kodierung eines $bit \in \{0, 1\}$ erfolgt dabei im wesentlichen in fünf Teilschritten: Im ersten Schritt wird anhand der Wahrscheinlichkeitsschätzung der Wert des weniger wahrscheinlichen Symbols ermittelt. Für dieses Symbol, auch $LPS$ (least probable symbol) in Unterscheidung zum $MPS$ (most probable symbol) genannt, wird die Wahrscheinlichkeitsschätzung $P_{LPS}$ im zweiten Schritt zur Berechnung der Breite $R_{LPS}$ des entsprechenden Teilintervalls herangezogen. Je nach Wert des zu kodierenden Bits $bit$ werden $L$ und $R$ im dritten Schritt aktualisiert. Im vierten Schritt wird die Wahrscheinlichkeitsschätzung je nach Wert des gerade kodierten Bits aktualisiert und schließlich wird das Codeintervall $R$ im letzten Schritt einer sogenannten Renormalisierung unterzogen, d. h. $R$ wird beispielsweise so reskaliert, dass die Bedingung $R \in [2^{b-2}, 2^{b-1})$ erfüllt ist. Dabei wird bei jeder Skalierungsoperation ein Bit ausgegeben.

Für weitere Details sei auf [10] verwiesen.

Der wesentliche Nachteil einer Implementierung, wie oben skizziert, besteht nun darin, dass die Berechnung der Intervallbreite $R_{LPS}$ eine Multiplikation pro zu kodierendem Symbol erfordert. Üblicherweise sind Multiplikationsoperationen, insbesondere, wenn sie in Hardware realisiert werden, aufwändig und kostenintensiv. In mehreren Forschungsarbeiten wurden daher Verfahren untersucht, diese Multiplikationsoperation durch eine geeignete Approximation zu ersetzen [11] [12] [13] [14]. Hierbei können die zu diesem Thema veröffentlichten Verfahren grob in drei Kategorien eingeteilt werden.

Die erste Gruppe von Vorschlägen zu einer multiplikationsfreien, binären arithmetischen Kodierung basiert auf dem Ansatz, die geschätzten Wahrscheinlichkeiten $P_{LPS}$ so zu approximieren, dass die Multiplikation im 2. Schritt von Figur 1 durch eine (oder mehrere) Schiebe- und Additionsoperation(en) ersetzt werden kann [11][14]. Hierzu werden im einfachsten Fall die Wahrscheinlichkeiten $P_{LPS}$ durch Werte in der Form $2^{-q}$ mit ganzahligem $q > 0$ angenähert.

In der zweiten Kategorie von approximativen Verfahren wird vorgeschlagen, den Wertebereich von $R$ durch diskrete Werte in der Form ($\frac{1}{2}$ - $r$) zu approximieren, wobei $r \in \{0\} \cup \{2^{-k} \mid k > 0, k$ ganzzahlig$\}$ gewählt wird [15][16].

Die dritte Kategorie von Verfahren zeichnet sich schließlich dadurch aus, dass dort sämtliche arithmetische Operationen durch Tabellenzugriffe ersetzt werden. Zu dieser Gruppe von Verfahren gehören einerseits der im JPEG-Standard verwendete Q-Coder und verwandte Verfahren, wie der QM- und MQ-Coder [12], und andererseits der quasi-arithmetische Koder [13]. Während das letztgenannte Verfahren eine drastische Einschränkung der zur Repräsentierung von $R$ verwendeten Anzahl $b$ von Bits vornimmt, um zu akzeptabel dimensionierten Tabellen zu gelangen, wird im Q-Coder die Renormalisierung von $R$ so gestaltet, dass $R$ zumindest näherungsweise durch 1 approximiert werden kann. Auf diese Art und Weise wird die Multiplikation zur Bestimmung von $R_{LPS}$ vermieden. Zusätzlich wird die Wahrscheinlichkeitsschätzung mittels einer Tabelle in Form einer Finite-State Machine betrieben. Für weitere Einzelheiten hierzu sei auf [12] verwiesen.

Der Erfindung liegt deshalb die Aufgabe zugrunde, ein Verfahren und eine Anordnung zur arithmetischen Enkodierung und Dekodierung von binären Zuständen sowie ein entsprechendes Computerprogramm und ein entsprechendes computerlesbares Speichermedium anzugeben, welche die erwähnten Nachteile beheben, insbesondere (a) keine Multiplikationen erfordern, (b) eine Wahrscheinlichkeitsschätzung ohne Berechnungsaufwand erlauben und (c) gleichzeitig ein Höchstmaß an Kodiereffizienz über einen weiten Bereich von typischerweise auftretenden Symbolwahrscheinlichkeiten gewährleisten.

Diese Aufgabe wird erfindungsgemäß gelöst durch die Merkmale im kennzeichnenden Teil der Ansprüche 1, 21, 22 und 23 im Zusammenwirken mit den Merkmalen im Oberbegriff. Zweckmäßige Ausgestaltungen der Erfindung sind in den Unteransprüchen enthalten.

Ein Verfahren zur arithmetischen Enkodierung und Dekodierung von binären Zuständen wird vorteilhafterweise so durchgeführt, daß in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Eine andere bevorzugte Ausführungsform des erfindungsgemäßen Verfahrens ist dadurch gekennzeichnet, daß ausgehend von dem aktuell auszuwertenden Intervall mit Breite R zur Bestimmung der zugeordneten Intervallbreite $Q_k$ ein Index $q\_index$ durch eine Schiebe- und Bitmaskierungsoperation angewendet auf die rechnerinterne/binäre Darstellung von $R$ ermittelt wird.

Als vorteilhaft erweist es sich auch, wenn ausgehend von dem aktuell auszuwertenden Intervall mit Breite $R$ zur Bestimmung der zugeordneten Intervallbreite $Q_k$ ein Index $q\_index$ durch eine Schiebeoperation angewendet auf die rechnerinterne/binäre Darstellung von $R$ und einem nachgeschalteten Zugriff auf eine Tabelle $Qtab$ ermittelt wird, wobei die Tabelle $Qtab$ die den durch Schiebeoperation vorquantisierten Werten von R entsprechenden Indizes von Intervallbreiten enthält.

Insbesondere erweist es sich als vorteilhaft, wenn die dem zu enkodierenden oder zu dekodierendem Symbol zugrundeliegende Wahrscheinlichkeitsschätzung mit Hilfe eines Indizes $p\_state$ einem Wahrscheinlichkeitszustand $P_n$ zugeordnet wird.

Es ist ebenfalls von Vorteil, wenn die Bestimmung der dem LPS entsprechenden Intervallbreite $R_{LPS}$ durch einen Zugriff auf eine Tabelle $Rtab$ erfolgt, wobei die Tabelle $Rtab$ die zu allen $K$ quantisierten Werten von $R$ und den $N$ verschiedenen Wahrscheinlichkeitszuständen korrespondierenden Werte der Intervallbreite $R_{LPS}$ als Produktwerte

($Q_k * P_n$) enthält. Der Rechenaufwand wird insbesondere dann reduziert, wenn die Bestimmung der dem LPS entsprechenden Intervallbreite $\mathbf{R_{LPS}}$ durch einen Zugriff auf die Tabelle Rtab erfolgt, wobei zur Auswertung der Tabelle der Quantisierungsindex *q_index* und der Index des Wahrscheinlichkeitszustand *p_state* verwendet wird.

Es ist weiterhin vorgesehen, daß bei dem erfindungsgemäßen Verfahren für die *N* verschiedenen repräsentativen Wahrscheinlichkeitszustände Übergangsregeln vorgegeben werden, wobei die Übergangsregeln angeben, welcher neue Zustand ausgehend von dem aktuell enkodierten oder dekodierten Symbol für das nächste zu kodierende oder dekodierende Symbol verwendet wird. Hierbei erweist es sich von Vorteil, wenn eine Tabelle *Next_State_LPS* angelegt wird, welche zu dem Index *n* des aktuell gegebenen Wahrscheinlichkeitszustands $P_n$ den Index m des neuen Wahrscheinlichkeitszustands $P_m$ bei Auftreten eines least probable symbol (LPS) enthält, und/oder eine Tabelle *Next_State_MPS* angelegt wird, welche zu dem Index *n* des aktuell gegebenen Wahrscheinlichkeitszustands $P_n$ den Index *m* des neuen Wahrscheinlichkeitszustands $P_m$ bei Auftreten eines most probable symbol (MPS) enthält.

Eine Optimierung des Verfahrens zur tabellengestützten binären arithmetischen Enkodierung und Dekodierung wird insbesondere dadurch erreicht, daß die zu allen *K* Intervallbreiten und zu allen *N* verschiedenen Wahrscheinlichkeitszuständen korrespondierenden Werte der Intervallbreite $R_{LPS}$ als Produktwerte ($Q_k * P_n$) in einer Tabelle *Rtab* abgelegt werden.

Eine weitere Optimierung erreicht man, wenn die Anzahl *K* der Quantisierungswerte und/oder die Anzahl *N* der repräsentativen Zustände in Abhängigkeit der vorgegebenen Genauigkeit der Kodierung und/oder in Abhängigkeit des verfügbaren Speicherplatzes gewählt werden.

Eine spezielle Ausführungsform der Enkodierung bei dem erfindungsgemäßen Verfahren umfasst folgende Schritte:

    1. Bestimmung des LPS
    2. Quantisierung von R:

$$q\_index = Qtab[R>>q]$$

    3. Bestimmung von $R_{LPS}$ und R:

$$R_{LPS} = Rtab[q\_index,p\_state]$$

$$R = R - R_{LPS}$$

    4. Berechnung des neuen Teilintervalls:

```
if (bit = LPS) then
        L ← L + R
        R ← R_LPS
        p_state ← Next_State_LPS[p_state]
        if (p_state = 0) then valMPS ← 1 - valMPS
else
        p_state ← Next_State_MPS[p_state],
```

    5. Renormalisierung von *L* und *R*, Schreiben von Bits,

wobei

**q_index**     den Index eines aus Qtab ausgelesenen Quantisierungswertes,
**p_state**     den aktuellen Zustand,
**$R_{LPS}$**     die dem LPS entsprechende Intervallbreite und
**valMPS**     das dem MPS entsprechende Bit

beschreiben.

Die Dekodierung in einer speziellen Ausführungsform des erfindungsgemäßen Verfahrens umfasst folgende Schritte:

1. Bestimmung des LPS
2. Quantisierung von R:

$$q\_index = Qtab[R>>q]$$

3. Bestimmung von $R_{LPS}$ und R:

$$R_{LPS} = Rtab\,[q\_index,p\_state]$$

$$R = R - R_{LPS}$$

4. Bestimmung von *bit*, je nach Lage des Teilintervalls:

```
if (V ≥ R) then
   bit ← LPS
   V ← V - R
   R ← R_LPS
      if (p_state = 0) valMPS ← 1 - valMPS
      p_state ← Next_State_LPS[p_state]
else




   bit ← MPS
   p_state ← Next_State_MPS[p_state]
```

5. Renormalisierung von R, Auslesen eines Bits und Aktualisierung von V,

wobei

**q_index** den Index eines aus Qtab ausgelesenen Quantisierungswertes,
**p_state** den aktuellen Zustand,
**$R_{LPS}$** die dem LPS entsprechende Intervallbreite,
**valMPS** das dem MPS entsprechende Bit und
**V** einen Wert aus dem Innern des aktuellen Teilintervalls

beschreiben.

In einer anderen speziellen Ausführungsform des erfindungsgemäßen Verfahrens ist vorgesehen, daß bei der Enkodierung und/oder Dekodierung die Berechnung des Quantisierungsindex *q_index* im zweiten Teilschritt nach der Berechnungsvorschrift erfolgt:

$$q\_index = (R >> q)\ \&\ Qmask$$

wobei Qmask eine in Abhängigkeit von K geeignet gewählte Bitmaske darstellt.

Bei Vorliegen einer uniformen Wahrscheinlichkeitsverteilung lässt sich eine weitere Optimierung des Verfahrens zur tabellengestützten binären arithmetischen Enkodierung und Dekodierung erreichen, indem

- bei der Enkodierung nach Anspruch 12 die Teilschritte 1 bis 4 nach folgender Berechnungsvorschrift erfolgen:

```
R ← R >> 1
if (bit = 1) then
    L ← L + R,
```

oder
die Teilschritte 1 bis 4 der Enkodierung nach Anspruch 12 gemäß folgender Berechnungsvorschrift erfolgen:

```
L ← L << 1
if (bit = 1) then
    L ← L + R
```

und bei der letzten Alternative die Renormalisierung (Teilschritt 5 nach Anspruch 12) mit verdoppelten Entscheidungsschwellwerten erfolgt und keine Verdoppelung von $L$ und $R$ vorgenommen wird,
- bei der Dekodierung nach Anspruch 13 die Teilschritte 1 bis 4 nach folgender Berechnungsvorschrift erfolgen:

```
R ← R >> 1
if (V ≥ R) then
    bit ← 1
    V ← V – R
else
    bit ← 0,
```

oder
die Teilschritte 1 bis 5 der Dekodierung nach Anspruch 13 gemäß folgender Berechnungsvorschrift ausgeführt werden:

1. Auslesen eines Bits und Aktualisierung von $V$
2. Bestimmung von bit, je nach Lage des Teilintervalls:

```
if (V ≥ R) then
    bit ← 1
    V ← V – R
else
bit ← 0.
```

Es erweist sich weiterhin als vorteilhaft, wenn die Initialisierung der Wahrscheinlichkeitsmodelle in Abhängigkeit eines Quantisierungsparameters SliceQP und vorgegebener Modellparameter m und n erfolgt, wobei SliceQP den am Beginn eines Slices vorgegebenen Quantisierungsparamter und m und n die Modellparameter beschreiben.

Ebenso ist es vorteilhaft, wenn die Initialisierung der Wahrscheinlichkeitsmodelle folgende Schritte umfasst:

1. prestate = min(max(1, ((m * SliceQP)>>4)+n),2*N)
2.

```
if (preState <= N) then
        p_state = N+1 - preState
        valMPS = 0
else
        p_state = preState - N
        valMPS = 1,
```

wobei valMPS das dem MPS entsprechende Bit, SliceQP den am Beginn eines Slices vorgegebenen Quantisierungsparamter und m und n die Modellparameter beschreiben.

Eine Anordnung zur arithmetischen Enkodierung und Dekodierung von binären Zuständen umfasst mindestens einen Prozessor, der (die) derart eingerichtet ist (sind), dass ein Verfahren zur arithmetischen Enkodierung und Dekodierung durchführbar ist, wobei in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Ein Computerprogramm zur arithmetischen Enkodierung und Dekodierung von binären Zuständen ermöglicht es einem Computer, nachdem es in den Speicher des Computers geladen worden ist, ein Verfahren zur arithmetischen Enkodierung und Dekodierung durchzuführen, wobei in einem ersten Schritt ein vorgebbarer Wertebereich für die Spezifizierung der Intervallbreite $R$ in $K$ repräsentative Intervallbreiten $\{Q_1, ..., Q_k\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Beispielsweise können solche Computerprogramme (gegen Gebühr oder unentgeltlich, frei zugänglich oder passwortgeschützt) downloadbar in einem Daten- oder Kommunikationsnetz bereitgestellt werden. Die so bereitgestellten Computerprogramme können dann durch ein Verfahren nutzbar gemacht werden, bei dem ein Computerprogramm nach Anspruch 22 aus einem Netz zur Datenübertragung wie beispielsweise aus dem Internet auf eine an das Netz angeschlossene Datenverarbeitungseinrichtung heruntergeladen wird.

Zur Durchführung eines Verfahrens zur arithmetischen Enkodierung und Dekodierung von binären Zuständen wird vorteilhafterweise ein computerlesbares Speichermedium genutzt, auf dem ein Programm gespeichert ist, das es einem Computer ermöglicht, nachdem es in den Speicher des Computers geladen worden ist, ein Verfahren zur arithmetischen Enkodierung und Dekodierung durchzuführen, wobei in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Das neue Verfahren zeichnet sich durch die Kombination dreier Merkmale aus. Zunächst erfolgt, ähnlich wie im Q-Coder die Wahrscheinlichkeitsschätzung mittels einer endlichen Zustandsmaschine (FSM: finite state machine), wobei die Generierung der $N$ repräsentativen Zustände der FSM offline erfolgt. Die entsprechenden Übergangsregeln werden dabei in Form von Tabellen abgelegt.

Zweites charakteristisches Merkmal der Erfindung ist eine Vorquantisierung der Intervallbreite $R$ auf eine Anzahl von $K$ vorab definierten Quantisierungswerten. Dies erlaubt bei geeigneter Dimensionierung von $K$ und $N$ die Erstellung einer Tabelle, die alle $K \times N$ Kombinationen von vorab berechneten Produktwerten $R \times P_{LPS}$ zu einer multiplikationsfreien Bestimmung von $R_{LPS}$ enthält.

Für die Verwendung der vorgestellten Erfindung in einer Umgebung, in der verschiedene Kontextmodelle zum Einsatz kommen, unter denen sich auch solche mit (nahezu) uniformer Wahrscheinlichkeitsverteilung befinden, wird als zusätzliches (optionales) Element ein separater Zweig in der Kodiermaschine vorgesehen, in der sich unter der Annahme einer Gleichverteilung die Bestimmung der Größen $L$ und $R$ sowie die Renormalisierung vom Rechenaufwand her nochmals deutlich reduziert.

Insgesamt beurteilt, erbringt die Erfindung insbesondere den Vorteil, dass sie einen guten Kompromiss zwischen hoher Kodiereffizienz auf der einen Seite und geringem Rechenaufwand auf der anderen Seite ermöglicht.

Die Erfindung wird nachfolgend anhand eines in der Zeichnung dargestellten Ausführungsbeispiels näher erläutert.

Es zeigen:

Figur 1 Darstellung der wesentlichen Operationen zur binären arithmetischen Kodierung;

Figur 2 Modifiziertes Schema zur tabellengestützten arithmetischen Enkodierung;

Figur 3 Prinzip der tabellengestützten arithmetischen Decodierung;

Figur 4 Prinzip der En- bzw. Dekodierung für binäre Daten mit uniformer Verteilung;

Figur 5 Alternative Realisierung der En- bzw. Dekodierung für binäre Daten mit uniformer Verteilung.

Figur 6 Initialisierung der Wahrscheinlichkeitsmodelle in Abhängigkeit eines Quantisierungsparameters SliceQP und vorgegebener Modellparameter m und n

Zunächst einmal soll jedoch der theoretische Hintergrund etwas näher erläutert werden:

Tabellengestützte Wahrscheinlichkeitsschätzung

Wie oben bereits näher erläutert, beruht die Wirkungsweise der arithmetischen Kodierung auf einer möglichst guten Schätzung der Auftrittswahrscheinlichkeit der zu kodierenden Symbole. Um eine Adaption an instationäre Quellenstatistiken zu ermöglichen, muss diese Schätzung im Laufe des Kodierungsprozesses aktualisiert werden. In der Regel werden hierzu herkömmlicherweise Verfahren verwendet, die mit Hilfe skalierter Häufigkeitszähler der kodierten Ereignisse operieren [17]. Bezeichnen $c_{LPS}$ und $c_{MPS}$ Zähler für die Auftrittshäufigkeiten von $LPS$ und $MPS,$ so lässt sich mittels dieser Zähler die Schätzung

$$P_{LPS} = \frac{c_{LPS}}{c_{LPS} + c_{MPS}} \tag{1}$$

vornehmen und damit die in Figur 1 skizzierte Operation der Intervallunterteilung ausführen. Für praktische Zwecke nachteilig ist die in Gleichung (1) erforderliche Division. Häufig ist es jedoch zweckmäßig und erforderlich, bei Überschreitung eines vorgegebenen Schwellwerts $C_{max}$ des Gesamtzählers $c_{Total} = c_{MPS} + c_{LPS}$ eine Reskalierung der Zählerstände vorzunehmen. (Man beachte in diesem Zusammenhang, dass bei einer b-bit-Darstellung von $L$ und $R$ die kleinste Wahrscheinlichkeit, die noch korrekt dargestellt werden kann, $2^{-b+2}$ beträgt, so dass zur Vermeidung der Unterschreitung dieser unteren Grenze gegebenenfalls eine Reskalierung der Zählerstände erforderlich ist.) Bei geeigneter Wahl von $C_{max}$ lassen sich die reziproken Werte von $c_{Total}$ tabellieren, so dass die in Gleichung (1) erforderliche Division durch einen Tabellenzugriff sowie eine Multiplikations- und Schiebeoperation ersetzt werden kann. Um jedoch auch diese arithmetischen Operationen zu vermeiden, wird in der vorliegenden Erfindung ein vollständig tabellengestütztes Verfahren zur Wahrscheinlichkeitsschätzung verwendet.

Zu diesem Zweck werden vorab in einer Trainingsphase repräsentative Wahrscheinlichkeitszustände $\{P_k \mid 0 \le k < N_{max}\}$ ausgewählt, wobei die Auswahl der Zustände einerseits von der Statistik der zu kodierenden Daten und andererseits von der Nebenbedingung der vorgegebenen Maximalanzahl $N_{max}$ von Zuständen abhängt. Zusätzlich werden Übergangsregeln definiert, die angeben, welcher neue Zustand ausgehend von dem aktuell kodierten Symbol für das nächste zu kodierende Symbol verwendet werden soll. Diese Übergangsregeln werden in Form zweier Tabellen bereitgestellt: $\{Next\_State\_LPS_k \mid 0 \leq k < N_{max}\}$ und $\{Next\_State\_MPS_k \mid 0 \leq k < N_{max}\}$, wobei die Tabellen für den Index $n$ des aktuell gegebenen Wahrscheinlichkeitszustands $P_n$ den Index $m$ des neuen Wahrscheinlichkeitszustands $P_m$ bei Auftreten eines LPS bzw. MPS liefern. Hervorzuheben sei an dieser Stelle, dass zur Wahrscheinlichkeitsschätzung im arithmetischen Enkoder bzw. Dekoder, so wie er hier vorgeschlagen wird, keine explizite Tabellierung der Wahrscheinlichkeitszustände notwendig ist. Vielmehr werden die Zustände nur anhand ihrer entsprechenden Indizes implizit adressiert, wie im nachfolgenden Abschnitt beschrieben. Zusätzlich zu den Übergangsregeln muss spezifiert werden, bei welchen Wahrscheinlichkeitszuständen der Wert des LPS und MPS vertauscht werden muss. In der Regel wird es nur einen solchen ausgezeichneten Zustand geben, der dann anhand seines Indizes $p\_state$ identifiziert werden kann.

Tabellengestützte Intervallunterteilung

Figur 2 zeigt das modifizierte Schema zur tabellengestützten arithmetischen Kodierung, wie sie hier vorgeschlagen wird. Nach Bestimmung des *LPS* wird zunächst die gegebene Intervallbreite $R$ mittels einer tabellierten Abbildung *Qtab* und einer geeigneten Schiebeoperation (um $q$ bit) auf einen quantisierten Wert $Q$ abgebildet. Alternativ kann die Quantisierung in Sonderfällen auch ohne Zuhilfenahme einer tabellierten Abbildung *Qtab* nur mit Hilfe einer Kombination von Schiebe- und Maskierungsoperationen ausgeführt werden. In der Regel wird hier eine relativ grobe Quantisierung auf $K = 2...8$ repräsentative Werte vorgenommen. Auch hier erfolgt, ähnlich wie im Fall der Wahrscheinlichkeitsschätzung, keine explizite Bestimmung von $Q$; vielmehr wird nur ein Index $q\_index$ auf $Q$ übergeben. Dieser Index wird nun zusammen mit dem Index $p\_state$ zur Charakterisierung des aktuellen Wahrscheinlichkeitszustands für die Bestimmung der Intervallbreite $R_{LPS}$ verwendet. Dazu wird der entsprechende Eintrag der Tabelle Rtab verwendet. Dort sind die zu allen $K$ quantisierten Werten von $R$ und $N_{max}$ verschiedenen Wahrscheinlichkeitszuständen korrespondierenden $K \cdot N_{max}$ Produktwerte $R \times P_{LPS}$ als Ganzzahlwerte mit einer Genauigkeit von i.a. $b$-2 Bits abgelegt. Für praktische Implementierungen ist hier eine Möglichkeit gegeben, zwischen dem Speicherbedarf für die Tabellengröße und der arithmetischen Genauigkeit, die letztlich auch die Effizienz der Kodierung bestimmt, abzuwägen. Beide Zielgrößen werden durch die Granularität der Repräsentierung von $R$ und $P_{LPS}$ bestimmt.

Im vierten Schritt der Figur 2 ist gezeigt, wie die Aktualisierung des Wahrscheinlichkeitszustands $p\_state$ in Abhängigkeit des gerade kodierten Ereignisses *bit* vorgenommen wird. Hier werden die im vorigen Abschnitt "Tabellengestützte Wahrscheinlichkeitsschätzung" bereits erwähnten Übergangstabellen *Next_State_LPS* und *Next_State_MPS* benutzt. Diese Operationen entsprechen dem in Figur 1 im 4. Schritt angegebenen, aber nicht näher spezifizierten Aktualisierungsprozeß.

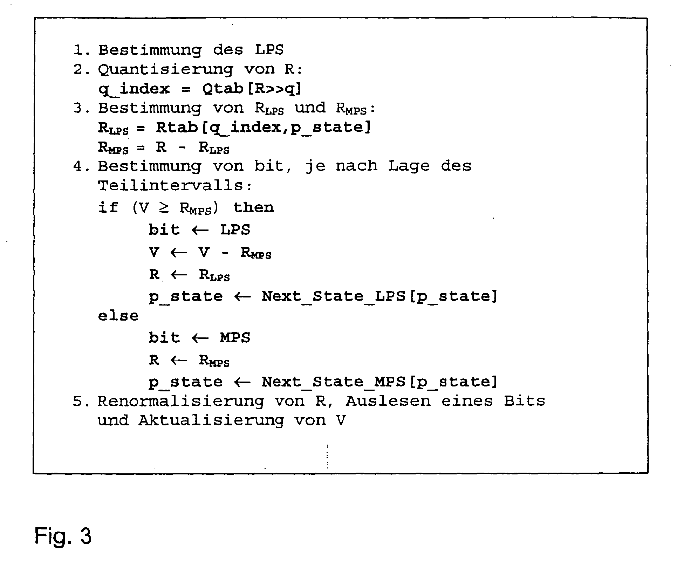

Figur 3 zeigt das korrespondierende Ablaufschema der tabellengestützten arithmetischen Dekodierung. Zur Charakterisierung des aktuellen Teilintervalls wird im Dekoder die Intervallbreite $R$ und ein Wert $V$ verwendet. Letzterer liegt im Innern des Teilintervalls und wird mit jedem gelesenen Bit sukzessive verfeinert. Wie aus der Figur 3 hervorgeht, werden die Operationen zur Wahrscheinlichkeitsschätzung und Bestimmung der Intervallbreite $R$ entsprechend denen des Enkoders nachgeführt.

Kodierung mit uniformer Wahrscheinlichkeitsverteilung

In Anwendungen, in denen z. B. vorzeichenbehaftete Werte kodiert werden sollen, deren Wahrscheinlichkeitsverteilung symmetrisch um die Null angeordnet ist, wird man zur Kodierung der Vorzeicheninformation in der Regel von einer Gleichverteilung ausgehen können. Da diese Information einerseits mit in den arithmetischen Bitstrom eingebettet werden soll, es andererseits aber nicht sinnvoll ist, für den Fall einer Wahrscheinlichkeit von $P \approx 0.5$ den immer noch relativ aufwändigen Apparat der tabellengestützten Wahrscheinlichkeitsschätzung und Intervallunterteilung zu benutzen, wird vorgeschlagen für diesen Spezialfall, optional eine gesonderte Enkoder-/Dekoder Prozedur zu benutzen, die sich wie folgt darstellt.

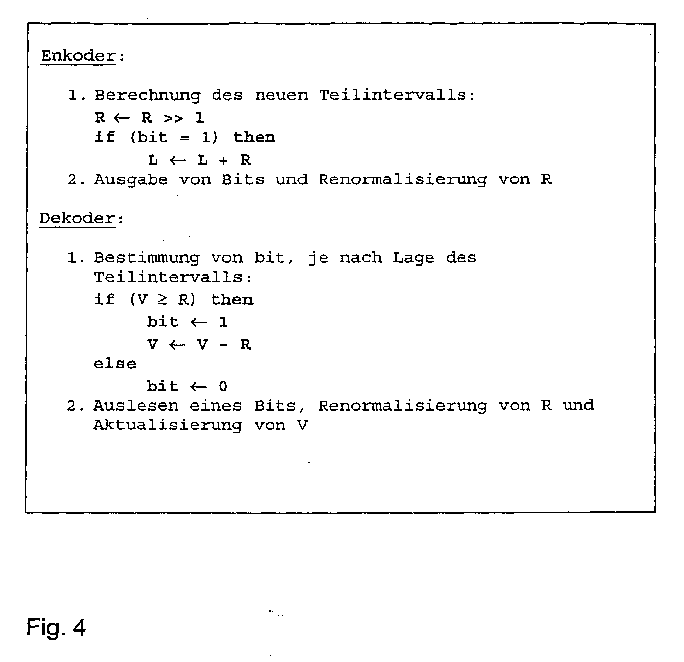

Im Enkoder lässt sich für diesen Spezialfall die Intervallbreite des neuen Teilintervalls durch eine einfache Schiebeoperation entsprechend einer Halbierung der Breite des Ausgangsintervalls $R$ bestimmen. Je nach Wert des zu kodierenden Bits wird dann die obere bzw. untere Hälfte von $R$ als neues Teilintervall gewählt (vgl. Figur 4). Die anschließende Renormalisierung und Ausgabe von Bits erfolgt wie im obigen Fall der tabellengestützten Lösung.

Im entsprechenden Dekoder reduzieren sich die notwendigen Operationen darauf, das zu dekodierende Bit anhand des Werts von $V$ relativ zur aktuellen Intervallbreite $R$ durch eine einfache Vergleichsoperation zu bestimmen. In dem Fall, dass das dekodierte Bit gesetzt wird, ist $V$ um den Betrag von $R$ zu reduzieren. Wie in Figur 4 dargestellt, wird die Dekodierung durch die Renormalisierung und die Aktualisierung von $V$ mit dem nächsten einzulesenden Bit abgeschlossen.

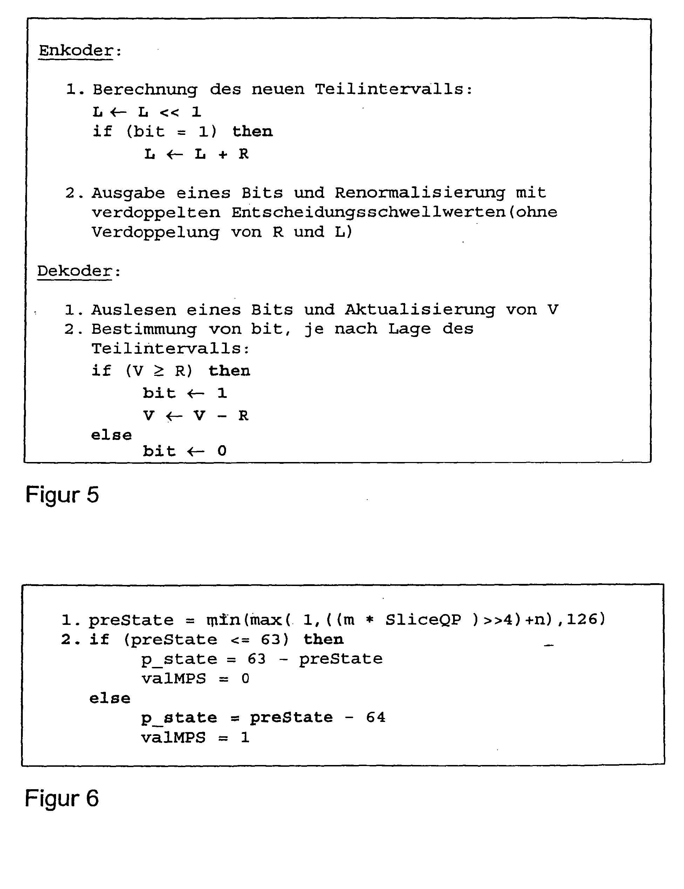

Eine alternative Realisierung der Kodierung von Ereignissen mit uniformer Wahrscheinlichkeitsverteilung ist in Figur 5 dargestellt. In dieser beispielhaften Implementierung wird die aktuelle Intervallbreite $R$ nicht modifiziert. Stattdessen wird im Enkoder zunächst $V$ durch eine Schiebeoperation verdoppelt. Je nach Wert des zu kodierenden Bits wird dann, ähnlich wie im vorigen Beispiel, die obere bzw. untere Hälfte von $R$ als neues Teilintervall gewählt (vgl. Figur 5). Die anschließende Renormalisierung und Ausgabe von Bits erfolgt wie im obigen Fall der tabellengestützten Lösung, mit dem Unterschied, dass die Verdoppelung von $R$ und $L$ nicht ausgeführt wird und die entsprechenden Vergleichsoperationen mit verdoppelten Schwellwerten ausgeführt werden.

Im entsprechenden Dekoder der alternativen Realisierung wird zunächst ein Bit ausgelesen und $V$ aktualisiert. Der zweite Schritt vollzieht sich in derselben Art und Weise wie Schritt 1 in Figur 4, d.h., das zu dekodierende Bit wird anhand des Werts von $V$ relativ zur aktuellen Intervallbreite $R$ durch eine einfache Vergleichsoperation bestimmt, und in dem Fall, in dem das dekodierte Bit gesetzt wird, ist $V$ um den Betrag von $R$ zu reduzieren (vgl. Figur 5).

Adressierung und Initialisierung der Wahrscheinlichkeitsmodelle

Jedes Wahrscheinlichkeitsmodell, wie es in der vorgestellten Erfindung Verwendung findet, wird mit Hilfe zweier Parameter gekennzeichnet: 1) der Index *p_state,* der den Wahrscheinlichkeitszustand des *LPS* charakterisiert, und 2) der Wert *valMPS* des *MPS.* Jede dieser beiden Größen muss zu Anfang der Enkodierung bzw. Dekodierung einer abgeschlossenen Kodiereinheit (in Anwendungen der Videokodierung etwa ein Slice) initialisiert werden. Die Initialisierungswerte können dabei aus Steuerinformationen, etwa dem Quantisierungsparameter (eines Slices) abgeleitet werden, wie es in Figur 6 beispielhaft dargestellt ist.

Vorwärtsgesteuerter Initialisierungsprozeß

Eine weitere Möglichkeit der Anpassung der Startverteilungen der Modelle wird durch folgende Methode bereitgestellt. Um eine bessere Anpassung der Initialisierungen der Modelle zu gewährleisten, kann im Enkoder eine Auswahl von vorgebenen Startwerten der Modelle bereitgestellt werden. Diese Modelle können zu Gruppen von Startverteilungen zusammengefasst und mit Indizes adressiert werden, so dass im Enkoder die adaptive Auswahl einer Gruppe von Startwerten erfolgt und dem Dekoder in Form eines Indizes als Seiteninformation übermittelt wird. Diese Methode wird als vorwärtsgesteuerter Initialisierungsprozeß bezeichnet.

**Quellennachweis**

[1] T. Wiegand, G. Sullivan, *"Draft Text* of *Final Draft International Standard (FDIS) of Joint Video Specification (ITU-T Rec. H.264 | ISO/IEC 14496-10 AVC)",* JVT-G050, March 2003.

[2] D. A. Huffman, "A Method for Construction of Minimum Redundancy code", Proc. IRE, Vol. 40, pp. 1098-1101, 1952.

[3] I. H. Witten, R. M. Neal, J. G. Cleary, "Arithmetic Coding for Data Compression", Communication of the ACM, Vol. 30, No. 6, pp. 520-540, 1987.

[4] G. G. Langdon, J. Rissanen, "A Simple General Binary Source code", IEEE Transactions on Information Theory, Vol. 28, pp. 800-803, 1982.

[5] C. E. Shannon, "A Mathematical Theory of Communication", Bell Syst. Tech. Journal, vol. 27, pp. 379-423, 623-656, 1948.

[6] P. Elias, in "Information Theory and Coding", N. Abramson (Ed.), New York, Mc-Gra-Hill, 1963.

[7] J. Rissanen, "Generalized Kraft Inequality and Arithmetic Coding", IBM J. Res. Develop., Vol. 20, pp. 198-203. 1976.

[8] R. C. Pasco, "Source Coding and Algorithms for Fast Data Compression", Ph. D. Dissertation, Stanford University, USA, 1976.

[9] G. G. Langdon, "An Introduction to Arithmetic Coding", IBM J. Res. Develop., Vol. 28, pp. 135-149, 1984.

[10] A. Moffat, R. M. Neal, I. H. Witten, "Arithmetic Coding Revisited", Proc. IEEE Data Compression Conference, Snowbird (USA), pp. 202-211, 1996.

[11] J. Rissanen, K. M. Mohiuddin, "A Multiplication-Free Multialphabet Arithmetic Arithmetic Code", IEEE Trans. on Communication, Vol. 37, pp. 93-98, 1989.

[12] W. B. Pennebaker, J. L. Mitchell, G. G. Langdon, R. B. Arps, "An Overview of the Basic Principles of the Q-Coder Adaptive Binary Arithmetic Coder", IBM J. Res. Develop., Vol. 32, pp. 717-726, 1988.

[13] P. G. Howard, J. S. Vitter, "Practical Implementations of Arithmetic Coding", in "Image and Text Compression", J. Storer (Ed.), Norwell (USA), Kluwer, 1992.

[14] L. Huynh, A. Moffat, "A Probability-Ratio Approach to Approximate Binary Arithmetic Coding", IEEE Trans. on Information Theory, Vol. 43, pp. 1658-1662, 1997.

[15] D. Chevion, E. D. Karnin, E. Walach, "High-Efficiency, Multiplication Free Approximation of Arithmetic Coding", Proc. IEEE Data Compression Conferenc, Snowbird (USA), pp. 43-52, 1991.

[16] G. Feygin, P. G. Gulak, P. Chow, "Minimizing Excess Code Length and VLSI Complexity in the Multiplication Free Approximation of Arithmetic Coding", Inform. Proc. Manag., vol. 30, pp. 805-816, 1994.

[17] D. L. Duttweiler, Ch. Chamzas, "Probability Estimation in Arithmetic and Adaptive-Huffman Entropy Coders", IEEE Trans. on Image Processing, Vol. 4, pp. 237- 246, 1995.

**Patentansprüche**

1. Verfahren zur arithmetischen Enkodierung eines zu enkodierenden Symbols mit binärem Zustand auf der Grundlage einer aktuellen Intervallbreite R und einer eine Wahrscheinlichkeitsschätzung für das zu enkodierende Symbol darstellenden Wahrscheinlichkeit, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei das Verfahren folgenden Schritt aufweist:

   Enkodieren des zu enkodierenden Symbols, indem folgende Teilschritte ausgeführt werden:

      Abbilden der aktuellen Intervallbreite auf einen Quantisierungsindex aus einer Mehrzahl von repräsentativen Quantisierungsindzes; und

      Durchführen der Intervallunterteilung durch Zugreifen unter Verwendung des Quantisierungsindex und des Wahrscheinlichkeitsindex auf eine Intervallteilungstabelle, um einen Teilintervallbreitenwert zu erhalten

   wobei eine Initialisierung der Wahrscheinlichkeitsmodelle in Abhängigkeit eines Quantisierungsmeters SliceQP und vorgegebener Modellparameter m und n erfolgt,
   wobei SliceQP den am Beginn eines Slices vorgegebenen Quantisierungsparameter und m und n die Modellparameter beschreiben.

2. Verfahren nach Anspruch 1, bei dem das Enkodieren ferner mittels folgenden Schrittes stattfindet:

   Aktualisieren der aktuellen Intervallbreite unter Verwendung des Intervallbreitenwertes, um eine neue, aktualisierte Intervallbreite zu erhalten.

3. Verfahren nach Anspruch 1 oder 2, bei dem der Teilintervallbreitenwert eine Breite eines Teilintervalls für ein zu enkodierendes Symbol mit einem weniger wahrscheinlichen Zustand aus einem aktuellen Intervall mit der aktuellen Intervallbreite angibt.

4. Verfahren nach einem der Ansprüche 1 bis 3, bei dem die Aktualisierung der aktuellen Intervallbreite ferner abhängig vom binären Zustand des zu enkodierenden Symbols durchgeführt wird.

5. Verfahren nach einem der vorhergehenden Ansprüche, das ferner folgenden Schritt aufweist:

   Adaption der Wahrscheinlichkeitsschätzung, wobei die Adaption der Wahrscheinlichkeitsschätzung das Nachschlagen, mit dem Wahrscheinlichkeitsindex, in einer LPS-Übergangsregeltabelle (*Next_State_LPS*), um einen neuen Wahrscheinlichkeitsindex zu erhalten, wenn das zu enkodierende Symbol einen weniger wahrscheinlichen Zustand aufweist, und das Nachschlagen, mit dem Wahrscheinlichkeitsindex, in einer MPS-Übergangsregeltabelle (*Next_State_MPS*), um einen neuen Wahrscheinlichkeitsindex zu erhalten, wenn das zu enkodierende Symbol einen wahrscheinlicheren Zustand aufweist, aufweist.

6. Verfahren nach Anspruch 5, das ferner das Umstellen eines den wahrscheinlicheren Zustand anzeigenden Wertes von einem ursprünglich angezeigten Zustand auf den binären Zustand des zu enkodierenden Symbols aufweist, wenn der Wahrscheinlichkeitsindex einem vorbestimmten Wahrscheinlichkeitsindex gleicht und das zu enkodierende Symbol einen von dem ursprünglichen angezeigten Zustand unterschiedlichen binären Zustand aufweist.

7. Verfahren nach einem der Ansprüche 1-6, bei dem der Teilschritt des Aktualisierens der aktuellen Intervallbreite folgende Schritte aufweist:

Gleichsetzen der neuen Intervallbreite mit der Differenz aus aktueller Intervallbreite minus dem Teilintervallbreitenwert; und

anschließend, falls das zu enkodierende Symbol einen weniger wahrscheinlichen Zustand aufweist, Gleichsetzen der neuen Intervallbreite mit dem Teilintervallbreitenwert.

**8.** Verfahren nach einem der vorhergehenden Ansprüche, bei dem ein aktuelles Intervall durch die aktuelle Intervallbreite und einen aktuellen Aufsatzpunkt repräsentiert ist, und das Enkodieren ferner durch folgenden Teilschritt durchgeführt wird:

Summieren des aktuellen Aufsatzpunktes und einer Differenz aus aktueller Intervallbreite und Teilintervallbreitenwert, um einen neuen, aktualisierten Aufsatzpunkt zu erhalten, wenn das zu kodierende Symbol einen weniger wahrscheinlichen Zustand aufweist.

**9.** Verfahren zur arithmetischen Dekodierung eines enkodierenten Symbols mit binärem Zustand auf der Grundlage einer aktuellen Intervallbreite R und einer eine Wahrscheinlichkeitsschätzung für das enkodierte Symbol darstellenden Wahrscheinlichkeit, wobei die Wahrscheinlichkeit durch einen Wahrscheinlichkeitsindex eines Wahrscheinlichkeitszustands aus einer Mehrzahl von repräsentativen Wahrscheinlichkeitszuständen repräsentiert ist, wobei das Verfahren folgenden Schritt aufweist:

Dekodieren des enkodierten Symbols, indem folgende Teilschritte ausgeführt werden:

Abbilden der aktuellen Intervallbreite auf einen Quantisierungsindex aus einer Mehrzahl von repräsentativen Quantisierungsindnizes; und

Durchführen der Intervallteilung durch Zugreifen unter Verwendung des Quantisierungsindex und des Wahrscheinlichkeitsindex auf eine Intervallteilungstabelle, um einen Teilintervallbreitenwert zu erhalten,

wobei eine Initialisierung der Wahrscheinlichkeitsmodelle in Abhängigkeit eines Quantisierungsmeters SliceQP und vorgegebener Modellparameter m und n erfolgt,
wobei SliceQP den am Beginn eines Slices vorgegebenen Quantisierungsparameter und m und n die Modellparameter beschreiben.

**10.** Verfahren nach Anspruch 9, bei dem das Dekodieren ferner mittels folgenden Schrittes stattfindet:

Aktualisieren der aktuellen Intervallbreite unter Verwendung des Teilintervallbreitenwertes, um eine neue, aktualisierte Intervallbreite zu erhalten.

**11.** Verfahren nach Anspruch 9 oder 10, bei dem der Teilintervallbreitenwert eine Breite eines Teilintervalls für ein enkodiertes Symbol mit einem weniger wahrscheinlichen Zustand aus einem aktuellen Intervall mit der aktuellen Intervallbreite angibt.

**12.** Verfahren nach einem der Ansprüche 9 bis 11, bei dem die Aktualisierung der aktuellen Intervallbreite ferner abhängig von einem im Inneren eines neuen Teilintervalls liegenden Wertes durchgeführt wird, das durch die aktuelle Teilintervallbreite und den im Inneren eines neuen Teilintervalls liegenden Wertes charakterisiert ist.

**13.** Verfahren nach Anspruch 12, bei dem das Dekodieren ferner mittels folgenden Teilschrittes durchgeführt wird:

Gleichsetzen des binären Zustands des enkodierten Symbols mit einem unter einem unwahrscheinlicheren und einen wahrscheinlicheren Zustand abhängig davon, ob der im Inneren des neuen Teilintervalls liegende Wert größer oder kleiner einer Differenz aus der aktuellen Intervallbreite und Teilintervallbreitewert ist.

**14.** Verfahren nach einem der Ansprüche 12 oder 13, bei dem das Enkodieren ferner mittels eines Aktualisierens des im Inneren des neuen Teilintervalls liegenden Wertes mit einem nächsten einzulesenden Bit durchgeführt wird.

**15.** Verfahren nach einem Ansprüche 12 bis 14, das ferner folgenden Schritt aufweist:

Aktualisierung der Wahrscheinlichkeitsschätzung, wobei die Aktualisierung der Wahrscheinlichkeitsschätzung das Nachschlagen, mit dem Wahrscheinlichkeitsindex, in einer LPS-Übergangsregeltabelle (*Next_State_LPS*), um einen neuen Wahrscheinlichkeitsindex zu erhalten, wenn der im Inneren des neuen Teilintervalls liegende Wert größer einer Differenz aus der aktuellen Intervallbreite und Teilintervallbreitewert ist, und das Nachschlagen, mit dem Wahrscheinlichkeitsindex, in einer MPS-Übergangsregeltabelle (*Next_State_MPS*), um einen neuen Wahrscheinlichkeitsindex zu erhalten, wenn der im Inneren des neuen Teilintervalls liegende Wert kleiner einer Differenz aus der aktuellen Intervallbreite und Teilintervallbreitewert ist, aufweist

16. Verfahren nach einem der Ansprüche 12 bis 15, das ferner das Umstellen eines den wahrscheinlicheren Zustand des enkodiereten Symbols anzeigenden Wertes von einem ursprünglich angezeigten Zustand auf einen unterschiedlichen binären Zustand aufweist, wenn der Wahrscheinlichkeitsindex einem vorbestimmten Wahrscheinlichkeitsindex gleicht und der im Inneren des neuen Teilintervalls liegende Wert größer einer Differenz aus der aktuellen Intervallbreite und Teilintervallbreitewert ist.

17. Verfahren nach einem der vorhergehenden Ansprüche, bei dem die aktuelle Intervallbreite mit einer Genauigkeit von b Bits und der von der Intervallteilungstabelle erhaltene Teilintervallbreitenwert mit einer Genauigkeit von b-2 Bits dargestellt ist.

18. Verfahren nach einem der vorhergehenden Ansprüche, bei dem
der Teilschritt des Abbildens das Anwenden einer Schiebe- und Bitmaskierungsoperation auf eine rechnerinterne/binäre Darstellung der aktuellen Intervallbreite aufweist.

19. Verfahren nach einem der vorhergehenden Ansprüche, bei dem
der Teilschritt des Abbildens das Anwenden einer Schiebeoperation auf eine rechnerinterne/binäre Darstellung der aktuellen Intervallbreite, um einen quantisierten Wert für die aktuelle Intervallbreite zu erhalten, und einen nachgeschalteten Zugriff auf eine Tabelle (*Qtab*)aufweist, den Quantisierungsindex zu erhalten.

20. Verfahren nach einem der voranstehenden Ansprüche, bei dem
in der Intervallteilungstabelle zu allen möglichen Quantisierungsindizes und zu allen Wahrscheinlichkeitsindizes korrespondierende Werte für die aktuelle Intervallbreite als Produktwerte zwischen Quantisierungsindex und in einer Tabelle *Rtab* abgelegt sind.

21. Verfahren nach einem der voranstehenden Ansprüche, das ferner folgenden Schritt aufweist:

Aktualisierung der Wahrscheinlichkeitsschätzung, wobei die Aktualisierung der Wahrscheinlichkeitsschätzung mittels Übergangsregeln durchgeführt wird, wobei die Übergangsregeln angeben, welcher neue Wahrscheinlichkeitszustand aus der Mehrzahl von Wahrscheinlichkeitszuständen ausgehend von dem zu enkodierenden bzw. enkodierten Symbol für ein nächstes zu enkodierendes bzw. enkodierende Symbol verwendet wird.

22. Verfahren nach einem der vorhergehenden Ansprüche, das ferner folgenden Schritt aufweist:

Aktualisierung der Wahrscheinlichkeitsschätzung, wobei die Aktualisierung der Wahrscheinlichkeitsschätzung das Nachschlagen, mit dem Wahrscheinlichkeitsindex, in einer Übergangsregeltabelle (*Next_State_LPS*) aufweist, um einen neuen Wahrscheinlichkeitsindex zu erhalten.

23. Verfahren nach einem der voranstehenden Ansprüche, bei dem
die Anzahl von möglichen Quantisierungsindizes und/oder die Anzahl der Wahrscheinlichkeitszustände in Abhängigkeit der vorgegebenen Genauigkeit der Kodierung und/oder in Abhängigkeit des verfügbaren Speicherplatzes gewählt sind.

24. Verfahren nach einem der vorhergehenden Ansprüche, das ferner folgenden Teilschritt aufweist:

Renormalisierung des neuen aktualisierten Aufsatzpunktes und der neuen, aktualisierten Intervallbreite.

25. Verfahren nach einem der Ansprüche 9 bis 24, bei dem die Dekodierung folgende Schritte umfaßt:

1. Bestimmung des LPS
2. Quantisierung von R:

$$q\_index = Qtab\ [R>>q]$$

3. Bestimmung von $R_{LPS}$ und R:

$$R_{LPS} = Rtab[q\_index, p\_state]$$

$$R = R - R_{LPS}$$

4. Bestimmung von *bit*, je nach Lage des Teilintervalls:

```
if (V ≥ R) then
   bit ← LPS
   V ← V − R
   R ← R_LPS
   if (p_state = 0) then valMPS ← 1 − valMPS
   p_state ← Next_State_LPS[p_state]
else
   bit ← MPS
p_state ← Next_State_MPS[p_state]
```

5. Renormalisierung von R, Auslesen eines Bits und Aktualisierung von V, wobei

| | |
|---|---|
| **q_index** | den Index eines aus Qtab ausgelesenen Quantisierungswertes, |
| **p_state** | den aktuellen Zustand, |
| **R_LPS** | die dem LPS entsprechende Intervallbreite, |
| **valMPS** | das dem MPS entsprechende Bit und einen Wert aus dem Innern des aktuellen Teilintervalls |

beschreiben.

**26.** Verfahren nach einem der voranstehenden Ansprüche, bei dem bei der Enkodierung bzw. Dekodierung die Abbildung auf den Quantisierungsindex *q_index* nach der Berechnungsvorschrift erfolgt:

$$q\_index = (R >> q)\ \&\ Qmask$$

wobei Qmask eine in Abhängigkeit von der Anzahl an Wahrscheinlichkeitszuständen geeignet gewählte Bitmaske, R die aktuelle Intervallbreite und q eine Anzahl von Bits darstellt.

**27.** Verfahren nach einem der voranstehenden Ansprüche, bei dem bei Vorliegen einer uniformen Wahrscheinlichkeitsverteilung

- bei der Enkodierung folgende Berechnungsvorschrift erfolgt:

```
R ← R >> 1
if (bit = 1) then
     L ← L + R,
```

oder
folgende Berechnungsvorschrift erfolgt:

```
L ← L << 1
if (bit = 1) then
    L ← L + R
```

und bei der letzten Alternative eine Renormalisierung mit verdoppelten Entscheidungsschwellwerten erfolgt und keine Verdoppelung von *L* und *R* vorgenommen wird,

- bei der Dekodierung nach Anspruch 13 folgende Berechnungsvorschrift erfolgt:

```
R ← R >> 1

if (V ≥ R) then
    bit ← 1
    V ← V - R
else
    bit ← 0,
```

oder
folgende Berechnungsvorschrift:

   3. Auslesen eines Bits und Aktualisierung von *V*
   4. Bestimmung von bit, je nach Lage des Teilintervalls:

```
if (V ≥ R) then
    bit ← 1
    V ← V - R
else
    bit ← 0.
```

**28.** Verfahren nach einem der voranstehenden Ansprüche, bei dem
die Initialisierung der Wahrscheinlichkeitsmodelle folgende Schritte umfaßt:

   1. preState = min(max(1, ((m * SliceQP) >>4)+n), 2*N)

   2.

```
if (preState <=N) then
    p_state = N - preState
    valMPS = 0
else
    p_state = preState - (N+1)
    valMPS = 1,
```

wobei valMPS das dem MPS entsprechende Bit, SliceQP den am Beginn eines Slices vorgegebenen Quantisierungsparameter und m und n die Modellparameter beschreiben.

29. Verfahren nach einem der voranstehenden Ansprüche, bei dem die Wahrscheinlichkeitsschätzung der Zustände mittels einer endlichen Zustandsmaschine (finite state machine; FSM) erfolgt.

30. Verfahren nach einem der voranstehenden Ansprüche, bei dem die Generierung der Wahrscheinlichkeitszustände offline erfolgt.

31. Verfahren nach einem der voranstehenden Ansprüche, bei dem die Auswahl der Zustände von der Statistik der zu kodierenden Daten und/oder von der Anzahl der Zustände abhängt.

32. Anordnung zur arithmetischen Enkodierung eines zu enkodierenden Symbols mit binärem Zustand auf der Grundlage einer aktuellen Intervallbreite R und einer eine Wahrscheinlichkeitsschätzung für das zu enkodierende Symbol darstellenden Wahrscheinlichkeit, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei die Vorrichtung folgendes Merkmal aufweist:

einer Einrichtung zur Enkodieren des zu enkodierenden Symbols, die folgende Einrichtungen aufweist:

eine Einrichtung zum Abbilden der aktuellen Intervallbreite auf einen Quantisierungsindex aus einer Mehrzahl von repräsentativen Quantisierungsindizes; und

eine Einrichtung zur Durchführung der Intervallunterteilung durch Zugreifen unter Verwendung des Quantisierungsindex und des Wahrscheinlichkeitsindex auf eine Intervallteilungstabelle, um einen Teilintervallbreitenwert zu erhalten,

wobei die Einrichtung zum Enkodieren derart ausgebildet ist, dass die Initialisierung der Wahrscheinlichkeitsmodelle in Abhängigkeit eines Quantisierungsmeters SliceQP und vorgegebener Modellparameter m und n erfolgt, wobei SliceQP den am Beginn eines Slices vorgegebenen Quantisierungsparameter und m und n die Modellparameter beschreiben.

33. Anordnung zur arithmetischen Dekodierung eines enkodierenten Symbols mit binärem Zustand auf der Grundlage einer aktuellen Intervallbreite $R$ und einer eine Wahrscheinlichkeitsschätzung für das enkodierte Symbol darstellenden Wahrscheinlichkeit, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei die Vorrichtung folgendes Merkmal aufweist:

eine Einrichtung zum Dekodieren des enkodierten Symbols, das folgende Einrichtungen aufweist:

eine Einrichtung zum Abbilden der aktuellen Intervallbreite auf einen Quantisierungsindex aus einer Mehrzahl von repräsentativen Quantisierungsindizes; und

eine Einrichtung zur Durchführung der Intervallunterteilung durch Zugreifen unter Verwendung des Quantisierungsindex und des Wahrscheinlichkeitsindex auf eine Intervallteilungstabelle, um einen Teilintervallbreitenwert zu erhalten,

wobei die Einrichtung zum Enkodieren derart ausgebildet ist, dass die Initialisierung der Wahrscheinlichkeitsmodelle in Abhängigkeit eines Quantisierungsmeters SliceQP und vorgegebener Modellparameter m und n erfolgt, wobei SliceQP den am Beginn eines Slices vorgegebenen Quantisierungsparameter und m und n die Modellparameter beschreiben.

34. Computerprogramm, das es einem Computer ermöglicht, nachdem es in den Speicher des Computers geladen worden ist, ein Verfahren zur arithmetischen Enkodierung eines zu enkodierenden Symbols mit binärem Zustand auf der Grundlage einer aktuellen Intervallbreite $R$ und einer eine Wahrscheinlichkeitsschätzung für das zu enkodierende Symbol darstellenden Wahrscheinlichkeit durchzuführen, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei das Verfahren folgenden Schritt aufweist:

Enkodieren des zu enkodierenden Symbols, indem folgende Teilschritte ausgeführt werden:

Abbilden der aktuellen Intervallbreite auf einen Quantisierungsindex aus einer Mehrzahl von repräsentativen Quantisierungsindzes; und

Durchführen der Intervallunterteilung durch Zugreifen unter Verwendung des Quantisierungsindex und des Wahrscheinlichkeitsindex auf eine Intervallteilungstabelle, um einen Teilintervallbreitenwert zu erhalten,

wobei eine Initialisierung der Wahrscheinlichkeitsmodelle in Abhängigkeit eines Quantisierungsmeters SliceQP und vorgegebener Modellparameter m und n erfolgt,
wobei SliceQP den am Beginn eines Slices vorgegebenen Quantisierungsparameter und m und n die Modellparameter beschreiben.

35. Computerprogramm, das es einem Computer ermöglicht, nachdem es in den Speicher des Computers geladen worden ist, ein Verfahren zur arithmetischen Dekodierung eines enkodierenten Symbols mit binärem Zustand auf der Grundlage einer aktuellen Intervallbreite $R$ und einer eine Wahrscheinlichkeitsschätzung für das enkodierte Symbol darstellenden Wahrscheinlichkeit durchzuführen, wobei die Wahrscheinlichkeit durch einen Wahrscheinlichkeitsindex eines Wahrscheinlichkeitszustands aus einer Mehrzahl von repräsentativen Wahrscheinlichkeitszuständen repräsentiert ist, wobei das Verfahren folgenden Schritt aufweist:

Dekodieren des enkodierten Symbols, indem folgende Teilschritte ausgeführt werden:

Abbilden der aktuellen Intervallbreite auf einen Quantisierungsindex aus einer Mehrzahl von repräsentativen Quantisierungsindnizes; und

Durchführen der Intervallteilung durch Zugreifen unter Verwendung des Quantisierungsindex und des Wahrscheinlichkeitsindex auf eine Intervallteilungstabelle, um einen Teilintervallbreitenwert zu erhalten,

wobei eine Initialisierung der Wahrscheinlichkeitsmodelle in Abhängigkeit eines Quantisierungsmeters SliceQP und vorgegebener Modellparameter m und n erfolgt,
wobei SliceQP den am Beginn eines Slices vorgegebenen Quantisierungsparameter und m und n die Modellparameter beschreiben.

36. Computerlesbares Speichermedium, auf dem in Programm gespeichert ist, das es einem Computer ermöglicht, nachdem es in den Speicher des Computer geladen worden ist, ein Verfahren zur arithmetischen Enkodierung eines zu enkodierenden Symbols mit binärem Zustand auf der Grundlage einer aktuellen Intervallbreite R und einer eine Wahrscheinlichkeitsschätzung für das zu enkodierende Symbol darstellenden Wahrscheinlichkeit durchzuführen, wobei die Wahrscheinlichkeit durch einen Wahrscheinlichkeitsindex zur Adressierung eines Wahrscheinlichkeitszustands aus einer Mehrzahl von repräsentativen Wahrscheinlichkeitszuständen repräsentiert ist, wobei das Verfahren folgenden Schritt aufweist:

Enkodieren des zu enkodierenden Symbols, indem folgende Teilschritte ausgeführt werden:

Abbilden der aktuellen Intervallbreite auf einen Quantisierungsindex aus einer Mehrzahl von repräsentativen Quantisierungsindzes; und

Durchführen der Intervallunterteilung durch Zugreifen unter Verwendung des Quantisierungsindex und des Wahrscheinlichkeitsindex auf eine Intervallteilungstabelle, um einen Teilintervallbreitenwert zu erhalten,

wobei eine Initialisierung der Wahrscheinlichkeitsmodelle in Abhängigkeit eines Quantisierungsmeters SliceQP und vorgegebener Modellparameter m und n erfolgt,
wobei SliceQP den am Beginn eines Slices vorgegebenen Quantisierungsparameter und m und n die Modellparameter beschreiben.

**37.** Computerlesbares Speichermedium, auf dem in Programm gespeichert ist, das es einem Computer ermöglicht, nachdem es in den Speicher des Computer geladen worden ist, ein Verfahren zur arithmetischen Dekodierung eines enkodierenten Symbols mit binärem Zustand auf der Grundlage einer aktuellen Intervallbreite *R* und einer eine Wahrscheinlichkeitsschätzung für das enkodierte Symbol darstellenden Wahrscheinlichkeit durchzuführen, wobei die Wahrscheinlichkeit durch einen Wahrscheinlichkeitsindex eines Wahrscheinlichkeitszustands aus einer Mehrzahl von repräsentativen Wahrscheinlichkeitszuständen repräsentiert ist, wobei das Verfahren folgenden Schritt aufweist:

Dekodieren des enkodierten Symbols, indem folgende Teilschritte ausgeführt werden:

Abbilden der aktuellen Intervallbreite auf einen Quantisierungsindex aus einer Mehrzahl von repräsentativen Quantisierungsindnizes; und

Durchführen der Intervallteilung durch Zugreifen unter Verwendung des Quantisierungsindex und des Wahrscheinlichkeitsindex auf eine Intervallteilungstabelle, um einen Teilintervallbreitenwert zu erhalten,

wobei eine Initialisierung der Wahrscheinlichkeitsmodelle in Abhängigkeit eines Quantisierungsmeters SliceQP und vorgegebener Modellparameter m und n erfolgt,
wobei SliceQP den am Beginn eines Slices vorgegebenen Quantisierungsparameter und m und n die Modellparameter beschreiben.

**38.** Computerlesbares Speichermedium, auf dem ein Programm gespeichert ist, das es einem Computer ermöglicht, nachdem es in den Speicher des Computers geladen worden ist, ein Verfahren gemäß einem der Ansprüche 34 und 35 durchzuführen.

1. Bestimmung des LPS
2. Berechnung der Größen $R_{LPS}$ und $R_{MPS}$:
   $R_{LPS} = R \times P_{LPS}$
   $R_{MPS} = R - R_{LPS}$
3. Berechnung des neuen Teilintervalls:
   **if** (bit = LPS) **then**
         $L \leftarrow L + R_{MPS}$
         $R \leftarrow R_{LPS}$
   **else**
         $R \leftarrow R_{MPS}$
4. Aktualisierung der Wahrscheinlichkeitsschätzung $P_{LPS}$
5. Ausgabe von Bits und Renormalisierung von R

## Fig. 1

1. Bestimmung des LPS
2. Quantisierung von R:
   **q_index = Qtab[R>>q]**
3. Bestimmung von $R_{LPS}$ und $R_{MPS}$:
   **$R_{LPS}$ = Rtab[q_index,p_state]**
   $R_{MPS} = R - R_{LPS}$
4. Berechnung des neuen Teilintervalls:
   **if** (bit = LPS) **then**
         $L \leftarrow L + R_{MPS}$
         $R \leftarrow R_{LPS}$
         **p_state $\leftarrow$ Next_State_LPS[p_state]**
   **else**
         $R \leftarrow R_{MPS}$
         **p_state $\leftarrow$ Next_State_MPS[p_state]**

## Fig. 2

1. Bestimmung des LPS
2. Quantisierung von R:
   $q\_index = Qtab[R>>q]$
3. Bestimmung von $R_{LPS}$ und $R_{MPS}$:
   $R_{LPS} = Rtab[q\_index,p\_state]$
   $R_{MPS} = R - R_{LPS}$
4. Bestimmung von bit, je nach Lage des Teilintervalls:
   if $(V \geq R_{MPS})$ then

         bit $\leftarrow$ LPS

         $V \leftarrow V - R_{MPS}$

         $R \leftarrow R_{LPS}$

         p_state $\leftarrow$ Next_State_LPS[p_state]

   else

         bit $\leftarrow$ MPS

         $R \leftarrow R_{MPS}$

         p_state $\leftarrow$ Next_State_MPS[p_state]
5. Renormalisierung von R, Auslesen eines Bits und Aktualisierung von V

Fig. 3

Enkoder:

   1. Berechnung des neuen Teilintervalls:
     R ← R >> 1
     if (bit = 1) then
         L ← L + R
   2. Ausgabe von Bits und Renormalisierung von R

Dekoder:

   1. Bestimmung von bit, je nach Lage des
     Teilintervalls:
     if (V ≥ R) then
         bit ← 1
         V ← V - R
     else
         bit ← 0
   2. Auslesen eines Bits, Renormalisierung von R und
     Aktualisierung von V

Fig. 4

```
Enkoder:

    1. Berechnung des neuen Teilintervalls:
       L ← L << 1
       if (bit = 1) then
             L ← L + R

    2. Ausgabe eines Bits und Renormalisierung mit
       verdoppelten Entscheidungsschwellwerten(ohne
       Verdoppelung von R und L)

Dekoder:

    1. Auslesen eines Bits und Aktualisierung von V
    2. Bestimmung von bit, je nach Lage des
       Teilintervalls:
       if (V ≥ R) then
             bit ← 1
             V ← V - R
       else
             bit ← 0
```

Figur 5

```
    1. preState = min(max( 1,((m * SliceQP )>>4)+n),126)
    2. if (preState <= 63) then
             p_state = 63 - preState
             valMPS = 0
       else
             p_state = preState - 64
             valMPS = 1
```

Figur 6